(19) Europäisches Patentamt
European Patent Office
Office européen des brevets

(11) **EP 2 191 546 B1**

(12) **EUROPEAN PATENT SPECIFICATION**

(45) Date of publication and mention of the grant of the patent:
**17.01.2018 Bulletin 2018/03**

(51) Int Cl.:
*H01S 5/024* *(2006.01)*          *H01S 5/022* *(2006.01)*
*H01S 5/40* *(2006.01)*          *H01S 5/00* *(2006.01)*

(21) Application number: **08807113.9**

(22) Date of filing: **18.09.2008**

(86) International application number:
**PCT/IB2008/002442**

(87) International publication number:
**WO 2009/037555 (26.03.2009 Gazette 2009/13)**

(54) **HIGH POWER SEMICONDUCTOR LASER DIODES**

HOCHLEISTUNGS-HALBLEITERLASERDIODEN

DIODES LASER SEMICONDUCTRICES HAUTE PUISSANCE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **20.09.2007 US 973936 P**

(43) Date of publication of application:
**02.06.2010 Bulletin 2010/22**

(73) Proprietor: **II-VI Laser Enterprise GmbH**
**8045 Zürich (CH)**

(72) Inventors:
• **KREJCI, Martin**
  **CH-8002 Zürich (CH)**
• **LICHTENSTEIN, Norbert**
  **CH-8135 Langnau (CH)**
• **WEISS, Stefan**
  **CH-8135 Langnau (CH)**
• **TROGER, Hans Jörg**
  **CH-3942 Raron (CH)**

(74) Representative: **Barth, Carl Otto**
**ABACUS Patentanwälte**
**Klocke Späth Barth**
**Zürichstrasse 34**
**8134 Adliswil/Zürich (CH)**

(56) References cited:
**US-A- 4 427 993          US-A- 5 848 083**
**US-A1- 2006 045 153**

Remarks:
The file contains technical information submitted after the application was filed and not included in this specification

EP 2 191 546 B1

1     EP 2 191 546 B1     2

## Description

*Field of the Invention*

The present invention relates to the cooling system of semiconductor laser diodes, in particular high power broad area single emitter (BASE) laser diodes arranged in a bar structure of up to 30 and more diodes, now commonly used in many industrial applications. Such a laser bar may produce 100W or more of light power, each of the laser diodes producing at least 100mW output. It should be clear that, at powers of this magnitude, it is important to manage heat dissipation in order to achieve good product performance and lifetime. Usually, such a laser diode bar is arranged on a submount, mostly junction side down, which submount serves as "stress buffer" and transfers the heat to a cooling system. Output power and stability of laser diodes in bars are of crucial importance and any degradation during normal use is a significant disadvantage. One significant reason for degradation is the stress applied to the laser diodes as a result of the mismatch of the thermal properties, especially the thermal expansion coefficient (CTE), between the laser diodes and the submount and/or cooling system or mount. The present invention concerns an improved design and structure of such laser bar submounts. By maintaining the original form and planarity of the laser bar and its mount/submount, degradation of high power laser devices is significantly minimized or fully avoided.

*Background and Prior Art*

Today, one major problem when manufacturing industrial laser bars is the large thermal mismatch between the commonly used laser diodes and the cooler. For example, GaAs-based laser diode bars have a CTE $= 6.5 \times 10^{-6}$ K$^{-1}$, whereas the usual copper cooler has a CTE $= 16 \times 10^{-6}$ K$^{-1}$.

There are three common mounting technologies for industrial laser bars on copper coolers:

(1) The laser bar is directly attached to the copper cooler using a "soft solder", e.g. In, InAg, or InSn.
(2) The laser bar is attached to a "CTE-adjusted" CuW submount, consisting e.g. of a homogenized 10% Cu and 90% W submount, forming a bar-on-submount structure (BoS), using a "hard solder", e.g. AuSn, and then

(2a) mounting the BoS on the copper cooler using a "soft solder", e.g. In, InAg, or InSn, or
(2b) mounting the BoS on the cooper cooler using a "hard solder", e.g. AuSn, SnAgCu, or Pb-Sn.

For the following reasons, none of these three mounting technologies results in a satisfactory assembly for industrial laser bars:

One reason is the unsatisfactory stability of the solder interface which results in an unsatisfactory reliability. A drawback of "soft" (i.e. low melting point) solders is their instability under thermal cycling operation, e.g. on-off operation common in industrial laser applications. As a consequence, with the mounting technologies described in (1) and (2a) above, the limiting operating condition is not determined by the properties of the laser diodes, but by the poor stability of the solder interfaces. Tests have shown that for one particular diode design, the maximum drive current for a reliable operation is about 90A when using the mounting technology (1), i.e. direct mounting the diode onto the copper cooler using In. For the technology (2a), the maximum drive current is 120A, i.e. mounting the BoS on the copper cooler using InAg. When using hard solder only as described in (2b), it is 180A. As a consequence, "soft solder" technologies seem to be no option for future industrial laser bar generations to meet the market requirement of a very high optical output power.

For the temperature-induced deformation of a laser bar on or with its mount or submount, persons skilled in the art use the term "smile" as a descriptor because of its appearance. "Smile" of a laser device in this context is defined as the warping or curvature of a laser device along the length of the laser diode bar which is in the plane orthogonal to the emitted light beam, i.e. orthogonal to the emitted light beam. Thus, looking head-on into the light emitting facets of the laser diodes of the bar, the various facets do not form a straight line. Smile is generally believed to result from stress and the term is often used to imply that the device has been subject to thermal stress.

Because technology (1) avoids a submount, it allows the design of devices with better thermal conductivity than comparable devices using the technologies (2a) and (2b). Also, because of the low solder temperature and the ductility of the soft solder, devices assembled using this technology have low bow values, i.e. $<2\mu m$. Further, vertically stacked laser bar arrays for very high power output may be made smaller, thus enabling better and easier vertical collimation of the laser beam by lenses or other optical means. However, as mentioned above, the limited reliability of soft soldered devices in off-on operation is an important drawback of this technology.

Technology (2a) uses a submount which is CTE-matched to the laser bar and a ductile soft solder between the various parts. This results in low-bow and low-stress devices. Further, such devices are significantly more reliable than comparable devices assembled with technology (1). This behavior is based on the fact that, because of the missing submount in technology (1), the soft In-based solder interface is close to the light/heat-generating region responsible for thermal and thermo-mechanical driving forces, which, for an on-off operation mode, cause a degradation of soft solder interfaces. These driving forces are directly correlated to the spatio-

2

temporal temperature distribution in the solder interface. Because of the thermal spreading within the submount, the temperature distribution is more homogeneous for technology (2a) than for technology (1), where there is no submount acting as a heat spreader between the heat-generating region and the soft solder interface. Nevertheless, the maximum reliable operation power of devices assembled using technology (2a) is in many cases determined by the stability of the soft solder interface. This requires pure "hard solder" assembly technologies for reliable operation conditions of high power devices.

Technology (2b) offers such a pure hard solder assembly. The CuW submount, having a thermal expansion coefficient ($CTE_{sub}$) equal or close to the thermal expansion coefficient ($CTE_{bar}$) of the laser bar, acts as a stress buffer between the copper cooler and the laser bar. Nevertheless, the resulting smile/stress values are often too high - and therefore unacceptable - for applications which require precise beam shaping or small spectral width. Fast- and slow-axis collimation lenses typically require smile values of $2\mu m$ or less, and for the optical pumping of solid state or fiber lasers, spectral widths of a few nanometers FWHM (full width/half maximum) bandwidth are required.

Further, stress within a device has a significant impact on the reliability.
For some devices, e.g. devices having a stress-sensitive epitaxial structure, technology (2b) might lead to reliability problems, because e.g. a hard solder and a CuW submount are unable to compensate for the compressive stress in the device caused by the thermal mismatch between the laser/submount and the cooler.

Also, to eliminate the CTE-mismatch between diode and cooler, so-called CTE-matched coolers have been developed. Known technologies for CTE-matched coolers are:

- CuMoCu micro channel coolers;
- Cu-AIN micro channel coolers; and
- Al-C (nanoparticles) passive coolers.

Although these coolers are technically quite advanced, they have some disadvantages:

- they are (still) expensive and are therefore now used only for demonstration or "niche" applications;
- some users expect cooler reliability problems and therefore hesitate to switch to a CTE-matched cooler; and/or
- the thermal conductivity of the CTE-matched coolers is in general not as good as the thermal conductivity of a copper cooler with the same geometry.

Also, layered submounts have been developed to obtain a better match between the laser diode bar and the cooler, but these submounts aim to match the $CTE_{bar}$ of the laser bar to reduce the stress to the latter. Consequently, they do not solve the stress/smile problem of the complete device.

To summarize, despite the various partial solutions for the stress/smile problem of laser diode bar devices, there is still a need for a simple, cost-effective design of such devices.

*The Invention*

The present invention takes a different approach. It focuses on the final laser device and its properties by improving the design and/or structure of the submount. The idea in principle is to minimize, in the final device, the stress between the submount and the laser diode bar by pre-stressing the submount. According to the invention, this is done either by deforming, e.g. bending, the submount before or during assembly or by building up stress within the submount/laser bar subsystem during assembly of the latter. In other words, rather than matching the $CTE_{bar}$ of the laser bar, the submount is designed with a structure with "tailored tensile strength", which will be explained below.

Although these coolers are technically quite advanced, they have some disadvantages:

- they are (still) expensive and are therefore now used only for demonstration or "niche" applications;
- some users expect cooler reliability problems and therefore hesitate to switch to a CTE-matched cooler; and/or
- the thermal conductivity of the CTE-matched coolers is in general not as good as the thermal conductivity of a copper cooler with the same geometry.

Also, layered submounts have been developed to obtain a better match between the laser diode bar and the cooler, but these submounts aim to match the $CTE_{bar}$ of the laser bar to reduce the stress to the latter. Consequently, they do not solve the stress/smile problem of the complete device.

A specific example of a "CTE-adjusted" layered submount is described in Carter et al. US 2006/0045153 A1 disclosing a multi-layer metal submount having a CTE equal or greater than that of GaAs, but less than the CTE of the copper cooler. As described therein, the CTE of most of the submount layers is somewhere between the CTE of the laser bar and the CTE of the cooler. This seems to be a sort of logical approach of reducing the thermal mismatch and the resulting stress between a laser bar and a cooler. Apart from the difference that the above-cited patent application shows a cooler using a cooling fluid whereas the present invention does not require such a cooling fluid, the present invention uses a quasi unlogical approach by selecting a submount whose CTE does not match the CTE of the laser bar.

Another example of a "CTE-adjusted" layered submount is disclosed by Ha-den et al. USP 5 848 083 showing a layered submount which may be used for a high power laser bar or array. The submount comprises various layers of differing coefficients of thermal expansion (CTEs), some of them comprising stress-relief apertures. The submount with its mounting plate carrying the laser bar is CTE-matched to the latter by a stack of bulk layers with such stress-relief apertures and an auxiliary plate fixed to the stack opposite the mounting plate. Though this design uses a plurality of layers with differing CTEs, it corresponds to technology (2) described above insofar as it is a "CTE-adjusted" submount with the described shortcomings. Contrary to that, the present invention uses a submount whose CTE does not match the CTE of the laser bar.

A different approach of solving the thermal mismatch problem is disclosed in Fichot et al. US patent 4 427 993 which shows a "thermal stress relief plate" to compensate the difference of CTEs between a semiconductor and its cooper cooler. This stress relief plate has on its semiconductor receiving surface a lattice structure combined of two materials so that the resulting CTE on this surface achieves a CTE value between the semiconductor's CTE and the copper cooler's CTE. Again, as mentioned above, this is a quasi logical approach to reduce the thermal mismatch and the resulting stress between a laser bar and a cooler, here effected by a specific surface structure of different materials. Apart from the difference that this cited patent shows a cooler with a specifically structured surface which does not exist in the present invention, the latter, as mentioned earlier, uses a kind of antithetic approach by selecting a submount whose CTE does not match the CTE of the laser bar.

To summarize, despite the various partial solutions for the stress/smile problem of laser diode bar or other semiconductor devices, there is still a need for a simple, cost-effective design of such devices.

*The Invention*

As indicated above, the present invention takes a different approach. It focuses on the final laser device and its properties by improving the design and/or structure of the submount. The idea in principle is to minimize, in the final device, the stress between the submount and the laser diode bar by pre-stressing the submount. According to the invention, this is done either by deforming, e.g. bending, the submount before or during assembly or by building up stress within the submount/laser bar subsystem during assembly of the latter. In other words, rather than matching the $CTE_{bar}$ of the laser bar, the submount is designed with a structure with "tailored tensile strength", which will be explained below.

The basic principle is explained by the following example. Typically, a high power diode bar has a CTE much lower than that of the cooler. For example, a GaAs diode bar has a $CTE_{bar} = 6.5 \times 10^{-6} \ K^{-1}$ compared with a usual copper cooler with $CTE_{cooler} = 16 \times 10^{-6} \ K^{-1}$. Also, typically, the submount is thinner than the cooler. Often the cooler is about ten times thicker than the submount. Then, according to this invention, the average $CTE_{sub}$ of the submount is selected to be

$$CTE_{sub} = k * CTE_{bar},$$

with $0.4 < k < 0.9$.

When (hard) soldering the laser diode bar to the submount, which usually occurs at around 200-300°C, the different CTEs of the laser diode bar and the submount ($CTE_{sub} < CTE_{bar}$) result, after cooling down, in a stress at the interface between the laser diode bar and the submount. This stress exerts a stretching force to the laser diode bar, which may result in a more or less pronounced bending, i.e. smile, of the device.
When (hard) soldering this device to the cooler, again at about 200-300°C, the different CTEs of the submount and the cooler ($CTE_{sub} < CTE_{cooler}$) result, after cooling down, in a stress at the interface between the submount and the cooler. This stress exerts a compressive force to the submount. Usually, the stiffness and/or volume of the cooler prevents any noticeable bending of the completed device.
According to the present invention the forces within the submount are balanced such that the resulting force exerted on the laser diode bar is zero. The result is a laser device which not only maintains its planarity under various operating conditions but also has light output with only minimal aberrations with regard to frequency and/or spectrum.

The invention requires, of course, a selection of materials and thicknesses of the components used. Since the material of the laser diode bar is usually selected according to the desired output (power and frequency) and the material of the cooler is often given by design restriction or customer requirement, only the material of the submount can be selected according to its thermal and mechanical properties.

The process of soldering the bar onto the submount and the submount onto the cooler may either be performed in one or two steps.

As explained above, according to this invention, the submount, its CTE and/or structure is tailored in such a way that, in the final assembly, the submount exhibits no force or a predetermined force on the mounted laser diode bar by compensating the unavoidable tensile force by a compressive force of the cooler. In other words, the possible deformation of the laser bar is compensated by a submount, which not only acts as a stress buffer between cooler and laser bar, but which, thanks to its thermo-mechanical properties, exhibits a beneficial pretension on the laser bar.

A particular feature is to design the submount as a layered structure, e.g. as CuMoCu structure. Although layered submounts are not new, per se, they have not been prestressed (or preloaded) according to the invention until now, but have been designed such that the CTE of the submount as a whole matches the CTE of the laser diode bar to be soldered to the submount.

According to one embodiment of the invention, such a layered submount may advantageously be designed asymmetrically, e.g. as a MoCu layer with the Cu layer facing the cooler or as a CuMoCu sandwich with two Cu layers of differing thicknesses, the thicker Cu layer facing the cooler. Advantageously, the side with the higher CTE should face the cooler.

Another particular feature of this invention is to provide a laser/submount subunit which is prestressed, e.g. already bent (i.e. shows a smile). This may be done by bending the submount before soldering, e.g. by an asymmetric design of the submount, in which case the submount consists of a vertically asymmetric arrangement of layers with different CTEs. Pre-bending may also be accomplished by mechanical means before or during assembly. The pre-bending of the submount is in general 15μm or less.

As a result of this new approach of submount design, which may also be named a "technology of submounts with tailored tensile properties", and the possibility to mount laser diode bars, especially InGaAlAs-based laser diode bars, on copper or other coolers using hard solder technologies, the following benefits and advantages are obtained:

- low smile values, i.e. deformation, which results in better beam shaping, wave guide coupling, etc.;

- low stress in the active region, which results in high reliability of the laser device, precise spectral width, etc.;

- stable solder interface, which again results in high reliability.

It will thus be possible to increase the rated output power of laser devices without introducing smile and/or to decrease the smile of very high power laser devices. It also provides great freedom for the design of epitaxial structures and the designer can optimize the smile and stress values.

*Detailed Description of Preferred Embodiments*

In the following, embodiments of the invention will be described by reference to the drawings, in which are shown:

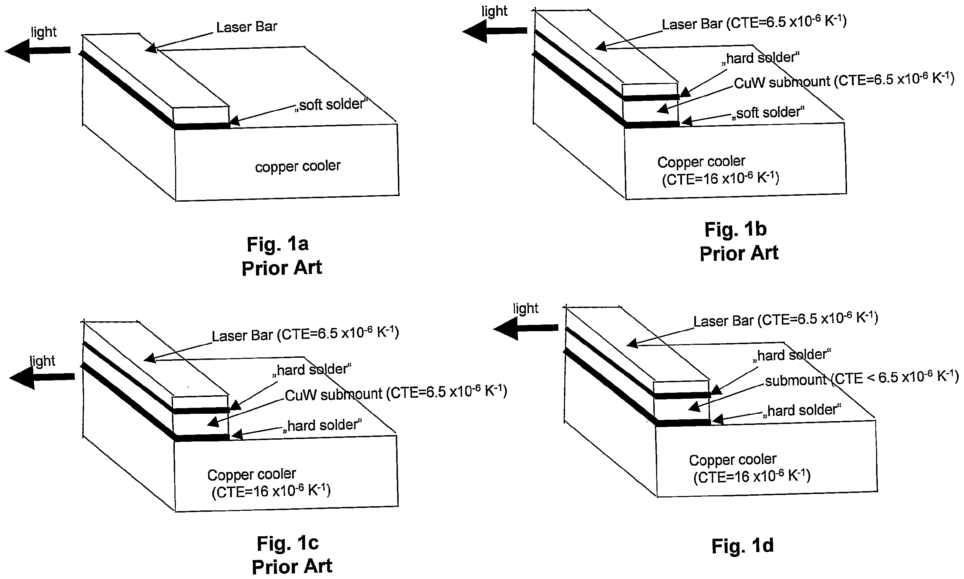

Fig. 1 a schematic drawing of a complete laser bar structure in different versions:

a laser bar mounted on a copper cooler using soft solder, e.g. technology (1);
a laser bar mounted on a CTE-matched submount using "hard solder" and mounted on a copper cooler using a "soft solder", e.g. technology (2a);

a laser bar mounted on a CTE-matched CuW submount and a copper cooler using "hard solder" on both interfaces;
a laser bar mounted on a "tailored tensile submount" according to the present invention and a copper cooler using "hard solder" on both interfaces.

Fig. 2 a general view of a typical embodiment of the invention;

Fig. 3 a description of "bow" and "smile" of laser bars;

Fig. 4 a symmetric, layered submount;

Fig. 5 an asymmetric, layered submount;

Fig. 6 an asymmetric, layered and structured submount;

Fig. 7 a more detailed view of an embodiment of the invention;

Figs. 8a, 8b an output comparison between a prior art laser device made by technology (Fig. 8a) and a laser device made according to the invention (Fig. 8b);

Figs. 9a, 9b a reliability comparison between laser devices made by a prior art technology (Fig. 9a) and laser devices made according to the invention (Fig. 9b);

Figs. 10a, 10b a comparison of smile values of two laser devices, one made by a prior art technology (Fig. 10a) and one made according to the invention (Fig. 10b);

Figs. 11a, 11b the spectral behaviour and the smile values of a laser device with a pre-bent submount according to the invention;

Figs. 12a, 12b the spectral behaviour and the smile values of a laser device with a planar, CTE-matched submount according to the prior art; and

Fig. 13 the initial bow of a CuMoCu submount plotted versus the final bow of the laser device.

Figs. 1a - 1c show three prior art embodiments of a laser diode bar on a massive copper cooler.

In the design shown in Fig. 1a, a laser bar is directly mounted to a copper cooler. Because of the large CTE difference between the laser bar and the cooler, $CTE_{bar} = 6.5 \times 10^{-6}$ K$^{-1}$ versus $CTE_{cooler} = 16 \times 10^{-6}$ K$^{-1}$, the "soft solder" technology (1) described above must be used to avoid overstressing the laser bar.

The design of in Fig. 1b differs in that it shows a CuW submount whose CTE matches the CTE of the laser bar, $CTE_{bar} = CTE_{sub} = 6.5 \times 10^{-6}$ K$^{-1}$. This design, above specified as technology (2a), avoids any stress between laser bar and submount. The stress is so-to-speak transferred to the interface between submount and cooler where the same CTE difference exist as in technology (1), but between other parts of the device as in Fig. 1a. There, a soft solder must be used to avoid overstressing.

Fig. 1c shows a prior art design which uses the same materials as the design of Fig. 1b, i.e. the CuW submount has about the same CTE as the cooler laser bar. However, the soft solder of Fig. 1b between submount and cooler is replaced by a hard solder as specified in technology (2b) above. This design has the disadvantage that the stress building up when the device cools down from soldering tends to bend the device which is unacceptable for many applications, especially where a precise beam shaping and/or a small spectral width are required.

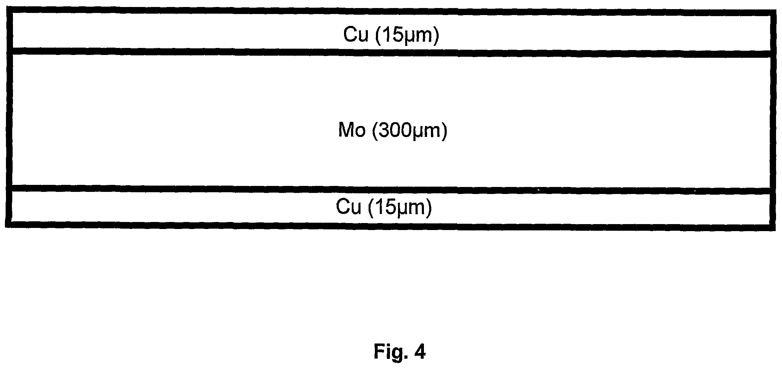

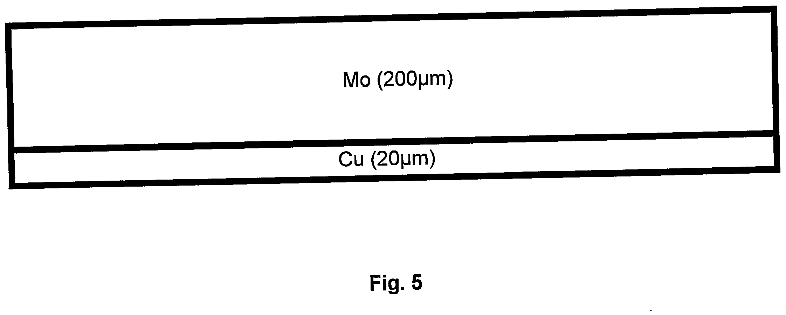

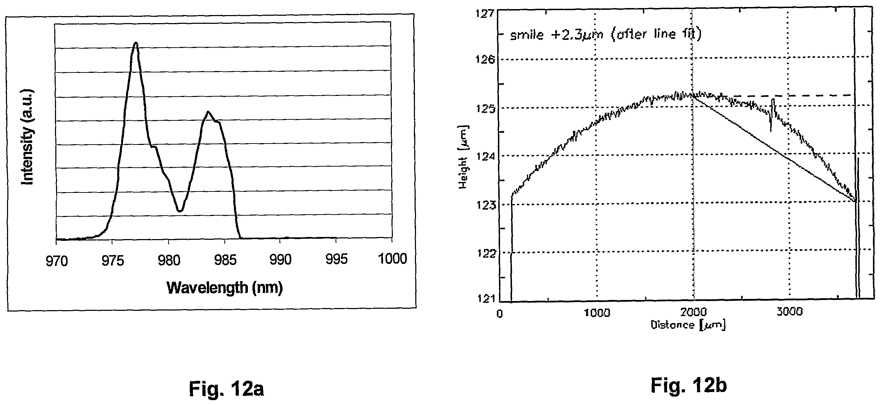

Fig. 1d depicts a design according to the invention. Here, the submount has a $CTE_{sub}$ selected to be smaller than the $CTE_{bar}$ of the laser bar, e.g. $CTE_{sub} = 5 \times 10^{-6}$ K$^{-1}$. The submount can be a solid material, e.g. an alloy or a mixture of two or more materials. It can also be a layered structure of symmetric design as shown in Fig. 4 or of asymmetric design as shown in Fig. 5 below. For optimizing the smile, the submount may have a bow of up to 15$\mu$m, caused by pre-bending and/or an asymmetric design. An example for a CuMoCu submount and an 8mm copper cooler is shown in Fig. 12. Typically the laser bar is first soldered to the submount using a hard solder process, e.g. AuSn. The solidification temperature of the solder is typically 200-350°C. Then, in a second solder process, the "bar on submount" (BoS) is soldered to the copper cooler using another hard solder process. In general, to avoid a re-flow in the first solder interface, a solder process with a lower process temperature is chosen for this second solder process. Alternatively, the two solder joint can be processed in one solder step, again using a hard solder process. Usually, the resulting thickness of the solder joints is 20$\mu$m or less so that they hardly affect the physical behaviour of the device.

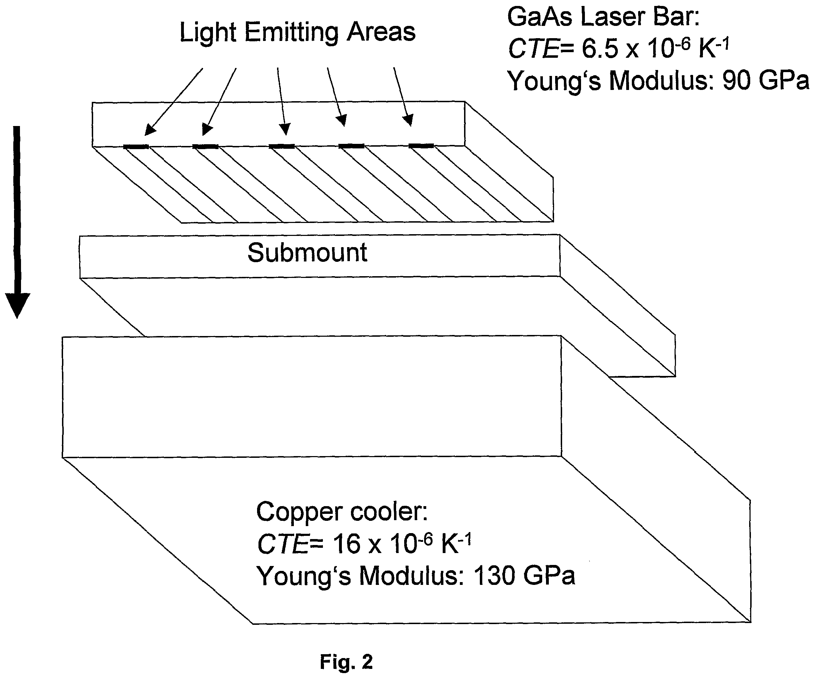

Fig. 2 displays essentially the same device as Fig. 1c in a three-dimensional "exploded" view. The laser bar is shown with its light emitting areas of the laser diodes. It should also be noted that the laser bar differs from the copper cooler not only in its CTE, but also in its Young's modulus as shown in the figure. The temperatures reached during manufacture of the laser device exceed the average operating temperature by 150-300K.

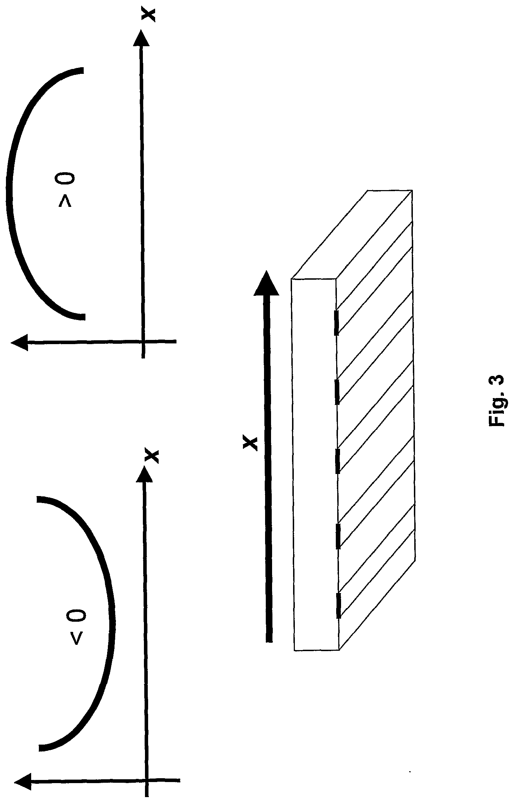

Fig. 3 explains the meaning of the term "bow" or "smile" of a semiconductor laser device as used in the present document. Of interest is the transversal or lateral bending of the device. The direction of bending is described by either "a grumpy bow" with bow values greater than zero or as "smiley bow" with bow values less than zero.

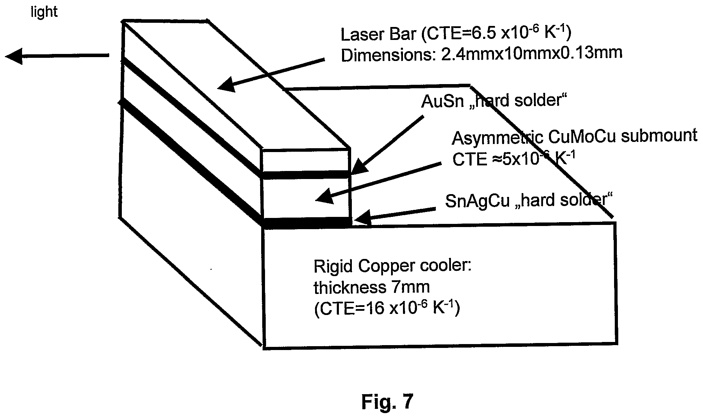

Fig. 4 shows a typical symmetric, layered design of a "tensile" submount according to the invention. An Mo substrate of 300$\mu$m is sandwiched between two 15$\mu$m Cu layers which may be plated or otherwise applied onto the Mo substrate. A submount with these dimensions has a resulting $CTE_{sub}$ of about $5 \times 10^{-6}$ K$^{-1}$. Fig. 7 shows a corresponding laser device in detail. The components are joined using hard solder processes with process temperatures between 200-350°C. The thickness of the solder joints is 20$\mu$m or less.

Fig. 5 depicts a typical asymmetric, layered design of a "tensile" submount which can be used for implementing the present invention. A Mo substrate of 200$\mu$m carries a Cu layer of 20$\mu$m on only one side. This side is the one to be soldered to the cooler. The average resulting $CTE_{sub}$ is estimated to be $5-6 \times 10^{-6}$ K$^{-1}$.

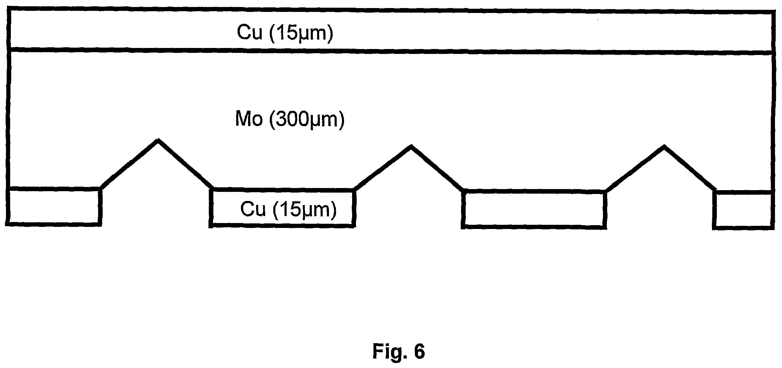

Fig. 6 shows a structured "tensile" submount which is dimensionally equivalent to the submount shown in Fig. 4, but has a broken underside. The structuring of submounts is a method to influence the mechanical properties of a mounted device. This technology is also applicable for the present invention.

Fig. 7 is a schematic drawing of an assembled laser device according to the invention using a "tensile" submount. The dimensions of the laser diode bar are 10mm x 2.4mm x 0.15 mm and its $CTE_{bar} = 6.5 \times 10^{-6}$ K$^{-1}$. The layered, asymmetric CuMoCu submount is 330$\mu$m thick and consists of a first Cu layer of 10$\mu$m on top, facing the laser bar, a Mo substrate of 300$\mu$m, and a second Cu layer of 20$\mu$m at the bottom, facing the cooler. This submount structure results in a $CTE_{sub}$ of approximately $5 \times 10^{-6}$ K$^{-1}$. The cooler is a rather rigid block of Cu of 8mm thickness. Both solder interfaces are made with a hard solder process, the laser/submount interface with an AuSn solder.

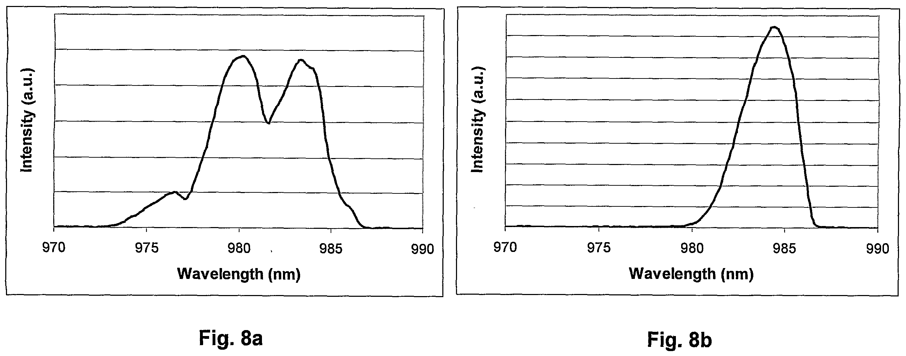

Figs. 8a and 8b compare wavelength measurements of two laser devices. A first laser device was manufactured with a prior art technology, here technology 2b, shown in Fig. 1c, using a CTE-matched CuW submount and two hard solder processes on a 8mm Cu cooler. Fig. 8a shows the measured results of this first laser device with a multi-peak behaviour and a rather broad spectral width which make it unsuitable for many applications. The second laser device was made as shown and described in connection with Fig. 6, i.e. according to the invention. Fig. 8b show the output: a clean single peak output and a small spectral width. This may be seen as indication that there is no or low stress at least in the laser/submount interface.

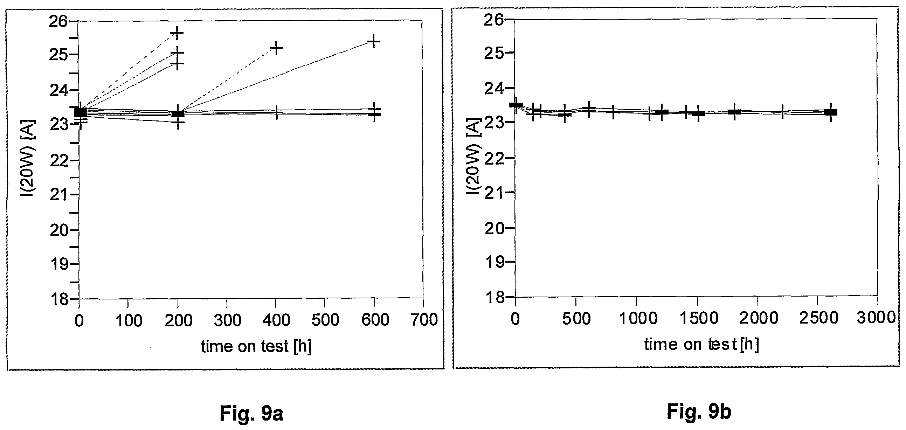

Figs. 9a and 9b compare reliabilities between two groups of laser devices. The devices from the first group were assembled using technology 2b, shown in Fig. 1c, i.e. using a CTE-matched CuW submount and two hard solder processes on a 8mm Cu cooler. The reliability test results are shown in Fig. 9a: an early degradation of operation current for 20W output because of stress-induced emitter failures. The devices from the second group were assembled as shown and described in connection with Fig. 8, i.e. according to the invention. Fig. 9b shows the reliabilty test result: a 2500h life test with no or only little degradation of the operation current for 20W output power.

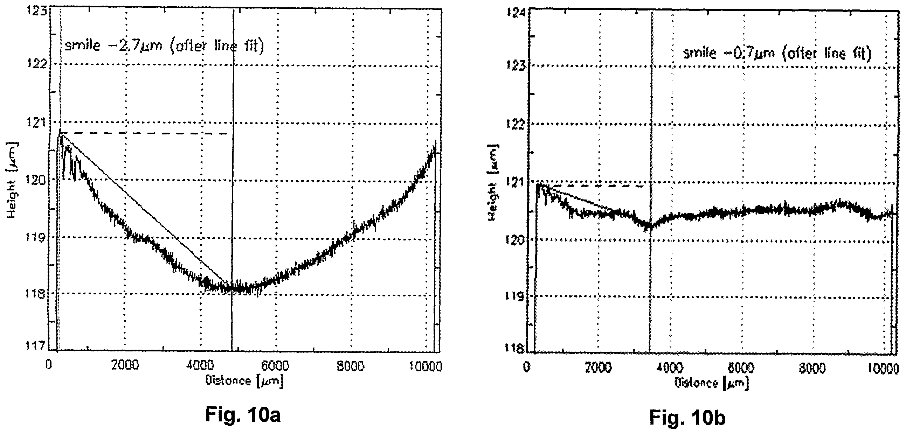

Figs. 10a and 10b show a comparison of smile values of two complete laser devices, in both cases mounted on a rigid Cu block as cooler. Fig. 10a depicts the measurement for a structure according to Fig. 2 with a symmetric submount according to Fig. 4. The maximum bow of the mounted device exceeds $2\mu$m. Fig. 10b shows the smile values for an essentially identical (except for the submount) laser device having an asymetric submount, e.g. according to Fig. 5: the maximum smile in this case is less than $1\mu$m.

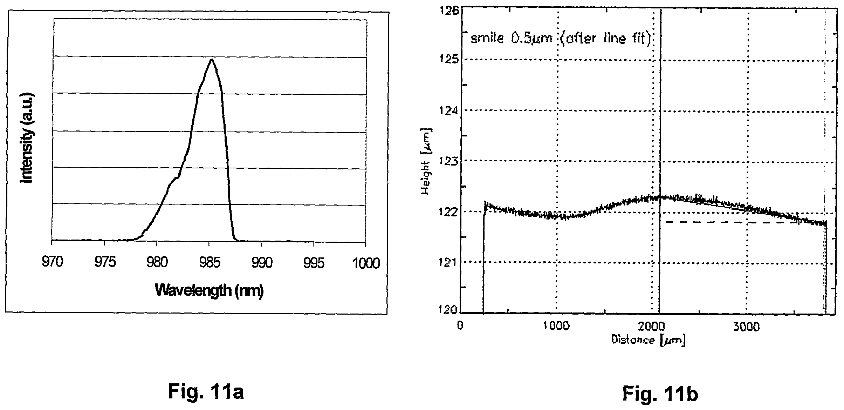

Figs. 11a and 11b show measurement results of a laser device according to the invention with a laser diode bar of 3.6mmx3.6mmx0.13mm hard soldered to a pre-bent Mo submount of $300\mu$m thickness. The initial smile of the submount is -$3\mu$m; the submount is curved towards the laser bar. (Cf. the "smiley shape" shown in Fig. 3). The laser/submount assembly is hard soldered to a 2.5mm thick Cu micro channel cooler. Fig. 11a shows the spectral behaviour of this laser device, clearly displaying a single peak and a rather narrow bandwidth. The smile of this laser device is depicted in Fig. 11 b; it is less than $1\mu$m, rather close to $0.5\mu$m.

Figs. 12a and 12b show measurement results of a laser device similar to the device described in connection with Figs. 11a and 11b with one important exception: the submount is a $400\mu$m thick CTE-matched CuW submount, i.e. has the same CTE as the 3.6mmx3.6mmx0.13mm laser bar hard soldered to the top of it. The submount has no initial smile, i.e. is planar. This laser/submount assembly is again hard soldered to a 2.5mm thick Cu micro channel cooler. Fig. 12a shows the spectral behaviour of this laser device, displaying an unfavourable double peak in the frequency spectrum and a broader bandwidth than the laser device according to Figs. 11 a and 11b. Regarding the smile, the difference between the two are equally significant: Whereas the laser device with the pre-bent Mo submount according to the invention shows far less than $1\mu$m smile (Fig. 11b), the laser with the CTE-matched, planar CuW submount shows about $2\mu$m smile, as apparent from Fig. 12b.

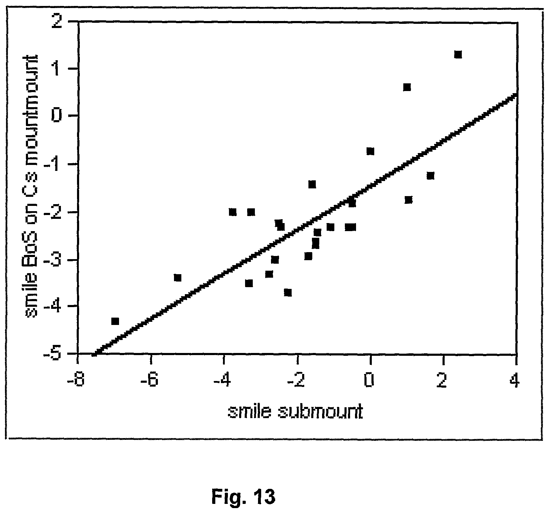

Finally, in Fig. 13 the initial bow of CuMoCu submounts is plotted versus the final bow of the device mounted using the investigated submounts on a 8 mm thick copper cooler, a so-called CS-mount. A positive bow value stands for a "smiley", a negative bow value for a "grumpy" shape. The graph shows that smallest final bow values are expected for submounts with an initial grumpy bow of about $3\mu$m. Measurements of the Cu layer thicknesses in the CuMoCu submounts showed that the initial bow of the submount is related to the thickness asymmetry of the CuMoCu submounts.

## Claims

1. A laser source of more than one W for generating light at a desired wavelength, said laser source comprising a bar of laser diodes, a submount onto which said laser bar is affixed, and a cooling element onto which said submount is affixed, wherein

   - said laser bar has a first coefficient of thermal expansion ($CTE_{bar}$),
   - said submount has a second coefficient of thermal expansion ($CTE_{sub}$), and
   - said cooling element has a third coefficient of thermal expansion ($CTE_{cool}$),
   - said third coefficient ($CTE_{cool}$) is selected higher than both said first coefficient ($CTE_{bar}$) and said second coefficient ($CTE_{sub}$),

   ***characterized in that***

   - said second coefficient ($CTE_{sub}$) is selected such that the average second coefficient (average of $CTE_{sub}$) is lower than both said first coefficient ($CTE_{bar}$) and said third coefficient ($CTE_{cool}$); and
   - said average second coefficient $CTE_{sub} = k * CTE_{bar}$ with $0.4 < k < 0.9$.

2. The laser source according to claim 1, *wherein* the $CTE_{sub}$ is constant across the submount's thickness.

3. The laser source according to claim 1, *wherein* the $CTE_{sub}$ varies across the submount's thickness.

4. The laser source according to claim 1 or 3, *wherein* the submount consists of or comprises at least two layers of different materials having different CTEs, resulting in a $CTE_{sub}$ which varies across the submount's thickness.

5. The laser source according to claim 4, *wherein* a first layer of the submount has a $CTE_{subA}$ and a second layer has a $CTE_{subB}$, $CTE_{subB}$ being different from, preferably greater than, $CTE_{subA}$, said first layer being located adjacent the laser bar and said second layer adjacent the cooling element.

6. The laser source according to claim 4, *wherein* the first layer of the submount is Cu of about 10-40$\mu$m, preferably 20$\mu$m, thickness and the second is Mo of about 100-400$\mu$m, preferably 200$\mu$m, thickness.

7. The laser source according to claim 4, *wherein* the submount consists of three layers, a first Cu layer of about 10-40$\mu$m, preferably 15$\mu$m, thickness, a Mo layer of about 100-400$\mu$m, preferably 300$\mu$m, thick-

ness, and a second Cu layer of about 20-40$\mu$m, preferably 15$\mu$m, thickness.

8. The laser source according to claim 1, *wherein* the submount comprises at least one structured or castellated surface, said structured or castellated surface being preferably located adjacent the cooling element.

9. The laser source according to claim 1, *wherein* the laser bar and the cooling element are hard soldered to the submount, in particular with an AuSn or an SnAgCu hard solder.

10. The laser source according to claim 1, *wherein* the laser bar is soldered to the submount with an AuSn hard solder, whereas the cooling element is soldered to said submount with an SnAgCu hard solder.

11. The laser source according to claim 1, *wherein* the submount or part of said submount is pre-bent.

12. A method for making a high power laser source of more than one W, said laser source including a bar of laser diodes, a cooling element and a submount between said laser bar and said cooling element, *comprising*

- selecting a submount whose average coefficient of thermal expansion (average of $CTE_{sub}$) is smaller than the coefficient of thermal expansion of the cooling element ($CTE_{cool}$) and smaller than the coefficient of thermal expansion of the bar of laser diodes ($CTE_{bar}$),
- hard soldering said submount to said cooling element, and
- hard soldering said bar of laser diodes to said submount
- said average coefficient $CTE_{sub} = k * CTE_{bar}$ with $0.4 < k < 0.9$.

13. The method according to claim 12, *wherein* the two soldering steps are executed simultaneously, preferably at temperatures of about 200-350 °C.

14. The method according to claim 12, *wherein* the submount or part of said submount is pre-bent before the bar of laser diodes is soldered to it.

**Patentansprüche**

1. Laserquelle mit mehr als ein W zur Generierung von Licht einer gewünschten Wellenlänge mit einem Barren Laserdioden, einem Submount, auf dem der Laser-Barren befestigt ist, und einem Kühlelement, auf dem dieser Submount befestigt ist, worin

- der Laser-Barren einen ersten Wärmeausdehnungskoeffizienten ($CTE_{bar}$) hat,
- der Submount einen zweiten Wärmeausdehnungskoeffizienten ($CTE_{sub}$) hat,
- das Kühlelement einen dritten Wärmeausdehnungskoeffizienten ($CTE_{cool}$) hat,
- wobei der dritte Wärmeausdehnungskoeffizient ($CTE_{cool}$) grösser als sowohl der erste ($CTE_{bar}$) wie auch der zweite Wärmeausdehnungskoeffizient ($CTE_{sub}$) gewählt wird,

***dadurch gekennzeichnet, dass***

- der zweite Wärmeausdehnungskoeffizient ($CTE_{sub}$) so gewählt wird, dass der mittlere zweite Wärmeausdehnungskoeffizient (mittlerer $CTE_{sub}$) niedriger als sowohl der erste Wärmeausdehnungskoeffizienten ($CTE_{bar}$) wie auch der dritte Wärmeausdehnungskoeffizient ($CTE_{cool}$) ist; und
- dieser mittlere zweite Wärmeausdehnungskoeffizient zu $CTE_{sub} = k * CTE_{bar}$ mit $0.4 < k < 0.9$ gewählt wird.

2. Die Laserquelle nach Anspruch 1, *worin* $CTE_{sub}$ konstant über die Dicke des Submounts ist.

3. Die Laserquelle nach Anspruch 1, *worin* $CTE_{sub}$ variabel über die Dicke des Submounts ist.

4. Die Laserquelle nach Anspruch 1 oder 3, *worin* der Submount aus mindestens zwei Schichten unterschiedlichen Materials mit unterschiedlichen CTEs besteht oder diese beinhaltet, woraus ein $CTE_{sub}$ resultiert, der variabel über die Dicke des Submounts ist.

5. Die Laserquelle nach Anspruch 4, *worin* eine erste Schicht des Submounts ein $CTE_{subA}$ aufweist und eine zweite Schicht ein $CTE_{subB}$, wobei $CTE_{subA}$ sich unterscheidet von, vorzugsweise grösser ist als $CTE_{subB}$, und diese erste Schicht an den Laser-Barren grenzt und diese zweite Schicht an das Kühlelement.

6. Die Laserquelle nach Anspruch 4, *worin* die erste Schicht des Submounts aus Cu besteht mit einer Dicke von 10-40$\mu$m, vorzugsweise 20$\mu$m, und die zweite Schicht aus Mo mit einer Dicke von 100-400$\mu$m, vorzugsweise 200$\mu$m.

7. Die Laserquelle nach Anspruch 4, *worin* der Submount drei Schichten aufweist, eine erste Schicht aus Cu mit einer Dicke von 10-40$\mu$m, vorzugsweise 15$\mu$m, eine zweite Schicht aus Mo mit einer Dicke von 100-400$\mu$m, vorzugsweise 300$\mu$m, und eine zweite Schicht aus Cu mit einer Dicke von

20-40$\mu$m, vorzugsweise 15$\mu$m.

8. Die Laserquelle nach Anspruch 1, *worin* der Submount zumindest ein strukturierte oder mit Aussparungen versehene Oberfläche aufweist, wobei diese strukturierte oder mit Aussparungen versehene Oberfläche vorzugsweise an das Kühlelement grenzt.

9. Die Laserquelle nach Anspruch 1, *worin* der Laser-Barren und das Kühlelement durch Hartlötung mit dem Submount verbunden sind, insbesondere mit einem AuSn oder SnAgCu Hartlot.

10. Die Laserquelle nach Anspruch 1, *worin* der Laser-Barren auf den Submount mit einem AuSn Hartlot gelötet ist, während das Kühlelement auf diesen Submount mit einem SnAgCu Hartlot gelötet ist.

11. Die Laserquelle nach Anspruch 1, *worin* der Submount oder ein Teil des Submounts vorgebogen ist.

12. Verfahren zur Herstellung einer Laserquelle von mehr als einem W, wobei diese Laserquelle einen Laser-Barren, ein Kühlelement und einen Submount zwischen dem Laser-Barren und dem Kühlelement aufweist,
*wobei*

- ein Submount gewählt wird, dessen mittlerer Wärmeausdehnungskoeffizient (mittlerer $CTE_{sub}$) kleiner als der Wärmeausdehnungskoeffizient des Kühlelements ($CTE_{cool}$) und kleiner als der Wärmeausdehnungskoeffizient des Laser-Barren ($CTE_{bar}$) ist,
- dieser Submount auf das Kühlelement hartgelötet wird,
- der Laser-Barren auf den Submount hartgelötet wird, und
- der mittlere Wärmeausdehnungskoeffizient $CTE_{sub} = k * CTE_{bar}$ beträgt, worin $0.4 < k < 0.9$.

13. Das Verfahren nach Anspruch 12, *worin* die beiden Hartlöt-Schritte gleichzeitig durchgeführt werden, vorzugsweise bei Temperaturen von ungefähr 200-350 °C.

14. Das Verfahren nach Anspruch 12, *worin* der Submount oder ein Teil des Submounts vorgebogen wird bevor der Laser-Barren auf ihn aufgelötet wird.

**Revendications**

1. Source laser de plus d'un W pour générer de la lumière à une longueur d'onde désirée, ladite source laser comprenant une barre de diodes laser, une embase sur laquelle ladite barre laser est fixée et un élément de refroidissement sur lequel ladite embase est fixée, dans laquelle

- ladite barre laser a un premier coefficient de dilatation thermique ($CTE_{bar}$),
- ladite embase a un deuxième coefficient de dilatation thermique ($CTE_{sub}$) et
- ledit élément de refroidissement a un troisième coefficient de dilatation thermique ($CTE_{cool}$),
- ledit troisième coefficient ($CTE_{cool}$) est sélectionné supérieur à la fois audit premier coefficient ($CTE_{bar}$) et audit deuxième coefficient ($CTE_{sub}$),

**caractérisée en ce que**

- ledit deuxième coefficient ($CTE_{sub}$) est sélectionné de sorte que ledit deuxième coefficient moyen (moyenne des $CTE_{sub}$) soit inférieur à la fois audit premier coefficient ($CTE_{bar}$) et audit troisième coefficient ($CTE_{cool}$) ; et
- ledit deuxième coefficient $CTE_{sub} = k * CTE_{bar}$, avec $0,4 < k < 0,9$.

2. Source laser selon la revendication 1, dans laquelle le $CTE_{sub}$ est constant à travers l'épaisseur de l'embase.

3. Source laser selon la revendication 1, dans laquelle le $CTE_{sub}$ varie à travers l'épaisseur de l'embase.

4. Source laser selon la revendication 1 ou 3, dans laquelle
l'embase est constituée de ou comprend au moins deux couches de matériaux différents ayant des CTE différents, avec pour résultat un $CTE_{sub}$ qui varie à travers l'épaisseur de l'embase.

5. Source laser selon la revendication 4, dans laquelle une première couche de l'embase a un $CTE_{subA}$ et une deuxième couche a un $CTE_{subB}$, $CTE_{subB}$ étant différent, de préférence supérieur à $CTE_{subA}$, ladite première couche étant située adjacente à la barre laser et ladite deuxième couche adjacente à l'élément de refroidissement.

6. Source laser selon la revendication 4, dans laquelle la première couche de l'embase est en Cu d'environ 10 à 40 $\mu$m, de préférence de 20 $\mu$m d'épaisseur et la deuxième est en Mo d'environ 100 à 400 $\mu$m, de préférence de 200 $\mu$m d'épaisseur.

7. Source laser selon la revendication 4, dans laquelle l'embase est constituée de trois couches, une première couche de Cu d'environ 10 à 40 $\mu$m, de pré-

férence de 15 μm d'épaisseur, une couche de Mo d'environ 100 à 400 μm, de préférence de 300 μm d'épaisseur et une deuxième couche de Cu d'environ 20 à 40 μm, de préférence de 15 μm d'épaisseur.

8. Source laser selon la revendication 1, dans laquelle l'embase comprend au moins une surface structurée ou crénelée, ladite surface structurée ou crénelée étant de préférence située adjacente à l'élément de refroidissement.

9. Source laser selon la revendication 1, dans laquelle la barre laser et l'élément de refroidissement sont brasés fort à l'embase, en particulier par une brasure forte AuSn ou une brasure forte SnAgCu.

10. Source laser selon la revendication 1, dans laquelle la barre laser est brasée à l'embase par une brasure forte AuSn, tandis que l'élément de refroidissement est brasé à ladite embase par une brasure forte SnAgCu.

11. Source laser selon la revendication 1, dans laquelle l'embase ou une partie de ladite embase est précintrée.

12. Procédé de fabrication d'une source laser de forte puissance de plus d'un W, ladite source laser incluant une barre de diodes laser, un élément de refroidissement et une embase entre ladite barre laser et ledit élément de refroidissement, consistant à

    - sélectionner une embase dont le coefficient de dilatation thermique moyen (moyenne des $CTE_{sub}$) est inférieur au coefficient de dilatation thermique de l'élément de refroidissement ($CTE_{cool}$) et au coefficient de dilatation thermique de la barre de diodes laser ($CTE_{bar}$),
    - braser fort ladite embase audit élément de refroidissement et
    - braser fort ladite barre de diodes laser à ladite embase,
    - ledit coefficient moyen $CTE_{sub}$ = k * $CTE_{bar}$, avec 0,4 < k < 0,9.

13. Procédé selon la revendication 12, dans lequel les deux étapes de brasage sont exécutées simultanément, de préférence à des températures d'environ 200 à 350 °C.

14. Procédé selon la revendication 12, dans lequel l'embase ou une partie de ladite embase est précintrée avant que la barre de diodes laser y soit brasée.

Fig. 1b
Prior Art

Fig. 1d

Fig. 1a
Prior Art

Fig. 1c
Prior Art

Light Emitting Areas

GaAs Laser Bar:
$CTE= 6.5 \times 10^{-6} \ K^{-1}$
Young's Modulus: 90 GPa

Submount

Copper cooler:
$CTE= 16 \times 10^{-6} \ K^{-1}$
Young's Modulus: 130 GPa

**Fig. 2**

EP 2 191 546 B1

Fig. 3

Fig. 4

Cu (15μm)

Mo (300μm)

Cu (15μm)

Fig. 5

Cu (15µm)

Mo (300µm)

Cu (15µm)

Fig. 6

light

Laser Bar (CTE=6.5 x10$^{-6}$ K$^{-1}$)
Dimensions: 2.4mmx10mmx0.13mm

AuSn „hard solder"

Asymmetric CuMoCu submount
CTE ≈5x10$^{-6}$ K$^{-1}$

SnAgCu „hard solder"

Rigid Copper cooler:
thickness 7mm
(CTE=16 x10$^{-6}$ K$^{-1}$)

**Fig. 7**

Fig. 8b

Fig. 8a

18

**Fig. 9a**

**Fig. 9b**

**Fig. 10a**

**Fig. 10b**

EP 2 191 546 B1

Fig. 11b

Fig. 11a

Fig. 12b

Fig. 12a

**Fig. 13**

EP 2 191 546 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060045153 A1
- US 5848083 A

- US 4427993 A